# EUROPÄISCHE PATENTSCHRIFT

(11) **EP 1 688 997 B1**
(45) Veröffentlichungstag und Bekanntmachung des Hinweises auf die Patenterteilung: **16.04.2014**
(21) Anmeldenummer: 05002187.2
(22) Anmeldetag: 02.02.2005
(51) Int. Cl.: H01L 23/49, H01L 25/065, H01L 23/31, H01L 23/495

(54) **Elektronisches Bauteil mit gestapelten Halbleiterchips**
Electronic component with stacked semiconductor chips
Composant électronique avec puces semi-conductrices empilées

(43) Veröffentlichungstag der Anmeldung: 09.08.2006
(73) Patentinhaber: Infineon Technologies AG, 85579 Neubiberg (DE)
(72) Erfinder: Theuss, Horst, Dr., 93173 Wenzenbach (DE); Weber, Michael, 84048 Mainburg (DE)
(74) Vertreter: Schweiger, Martin

(56) Entgegenhaltungen:
- US-A1- 2002 096 755
- US-A1- 2002 195 624
- US-A1- 2003 067 083
- US-A1- 2004 157 375
- US-A1- 2004 200 885
- US-B1- 6 586 825

## Beschreibung

Die folgende Erfindung betrifft ein elektronisches Bauteil mit gestapelten Halbleiterchips und ein Verfahren zu seiner Herstellung.

Ein gattungsgemäßes elektronisches Bauteil ist in der US 2003/0178 710 A1 und in der US 5 323 060 offenbart. Dort wird gezeigt, wie Abschnitte eines Halbleiterwafers mit einem Kunststoffträger verbunden werden, der mit einer so genannten "Tape"-Technologie auf einen Halbleiterchip aufgebracht wird. Anschließend wird mit einem Einzelbestückungsverfahrensschritt ein weiterer Halbleiterchip auf den Kunststoffbereich aufgesetzt. Schließlich wird der oben aufliegende Halbleiterchip mit einem Drahtbondverfahren kontaktiert. Alternativ zur Verwendung eines "Tape"-Verfahrens kann auch eine dicke Kleberschicht durch Dispensen auf den unteren Halbleiterchip aufgebracht werden.

Die DE 100 238 23 A1, die DE 103 10 617 A1 und die WO 2004/06413 A2 zeigen andere elektronische Bäuteile des Standes der Technik.

Die US 2004/0200885 A1 offenbart ein Verfahren zum Herstellen von Halbleiterbauteilen, bei dem Abstandshalter auf Kontaktflächen eines ersten Halbleiterchips aufgebracht werden, die nicht Teil der Schaltung sind. Ein zweiter Halbleiterchip wird auf den Abstandshaltern aufgebracht.

Die US 2003/0067083 A1 offenbart ein Verfahren zum Herstellen eines Halbleiterbauteils, bei dem zwei gestapelte Halbleiterchips über eine Klebstoffschicht verbunden sind. Die Kontaktfläche zwischen der Klebstoffschicht und dem oberen Halbleiterchip ist größer, als die Kontaktfläche zwischen der Klebstoffschicht und dem unteren Halbleiterchip.

Die US 2002/0096755 A1 offenbart ein Halbleiterbauteil mit zwei gestapelten Halbleiterchips. Die Halbleiterchips sind über Bonddrähte mit einem Substrat verbunden und die Bonddrähte auf dem unteren Halbleiterchip sind mit einer Isolierschicht abgedeckt.

Bei den im Stand der Technik bekannten Verfahren ist nachteilig, dass die Einzelbestückungsverfahren sehr aufwendig sind. Außerdem ist die Ablagegenauigkeit des Abstandshalters bzw. Spacers auf dem unteren Chip eingeschränkt, so dass sich mitunter Stabilitätsprobleme der beiden aufeinander abgelagerten Chips ergeben. Weiter besteht die Gefahr, dass zur Kontaktierung verwendete Wirebonds oder zur Herstellung benutzte Werkzeuge durch verlaufenden Kleber verschmutzt werden.

Die Erfindung geht von der Aufgabe aus, die Nachteile der im Stand der Technik bekannten Verfahren und Vorrichtungen zu vermeiden. So soll ein stabiler und zuverlässiger Chipstapel mit möglichst geringen Kosten hergestellt werden.

Diese Aufgabe wird durch den Gegenstand des Patentanspruchs 1 gelöst. Vorteilhafte Weiterbildungen ergeben sich aus den jeweiligen abhängigen Patentansprüchen.

Erfindungsgemäß wird ein Halbleiterbauteil geschaffen, zwei aufeinander gestapelte Modulkomponenten beispielsweise in Form von Halbleiterchips umfasst. Die Halbleiterchips stehen untereinander und/oder mit einem übergeordneten Schaltungsträger über Verbindungselemente elektrisch in Verbindung.

Ein derartiger Chipstapel hat den Vorteil, dass sogar ein Bereich über einer Oberflächenstruktur des unteren Halbleiterchips für einen Abstandshalter zwischen den Halbleiterchips genutzt werden kann und somit ein Anbringen von Verbindungselementen zwischen den beiden Modulkomponenten in den Randbereichen außerhalb der Oberflächenstruktur des unteren Halbleiterchips ermöglicht wird. Dazu ist die Höhe des Spacers in vorteilhafter Weise auf den Raumbedarf der zwischen den Modulkomponenten angeordneten Verbindungselemente angepasst.

Ein erfindungsgemäßer Spacer bzw. Abstandshalter weist Wände auf, die vorzugsweise aus einem photostrukturierbaren Material hergestellt sind, das die erforderlichen Dicken von mehreren 10 µm hat. Der Spacer kann bereits in einem vorhergehenden Prozess auf einen verwendeten Halbleiterchip aufgebracht werden.

Diese Wandstruktur ist vorzugsweise aus einem Polymer hergestellt, das für mehrere auf einem Wafer angeordnete Halbleiterchippositionen mittels eines Aufschleuderverfahrens aufgebracht werden kann. Die Strukturierung erfolgt dann auch in einem Parallelverfahren für viele Halbleiterchips gleichzeitig durch entsprechende Photolithographie. Somit weist in einer bevorzugten Ausführungsform der Erfindung der räumlich angekoppelte Hohlraumresonatorbereich eine ausgehärtete Photolackstruktur auf, die räumlich an die Oberflächenstruktur und insbesondere an die Kontaktflächen der Halbleiterchips angepasst ist und den Abstandshalter zwischen zwei aufeinander gestapelten Modulkomponenten bildet. Damit wird vorteilhafterweise beim Stapeln der Modulkomponenten Material und Montagezeit eingespart, die sonst beim Stapeln von einzelnen Halbleiterchips durch Vorbereiten und Einbringen von Abstandshalteelementen aufzuwenden ist.

Der abstandshaltende Spacer ist im Zentrum einer Modulkomponente bzw. Halbleiterchips angeordnet und auf den das Zentrum umgebenden Randbereichen sind die Verbindungselemente wie etwa Bonddrähte angebracht. Je nach Größe der zu stapelnden Modulkomponenten werden diese Verbindungselemente jeweils vor dem Stapeln der nächsten zu stapelnden Modulkomponente auf die Oberseite der darunter angeordneten Modulkomponente aufgebracht oder, wenn die flächige Erstreckung der Modulkomponenten im Stapel nacheinander abnimmt, können diese Verbindungselemente auch nach Aufbringen der gestapelten Modulkomponente montiert werden. Dabei hängt der zeitpunkt, bei dem fertigungstechnisch die Verbindungselemente zu den einzelnen Modulkomponenten eingebracht werden, auch von der Art der Verbindungselemente ab.

So können Verbindungselemente in Form von Durchkontakten durch die Halbleiter- oder Keramiksubstrate bereits bei der Oberflächenmontage der einzelnen Modulkomponenten übereinander miteinander verbunden werden. Weisen hingegen die Modulkomponenten als Verbindungselemente Bonddrähte auf, so werden diese von Kontaktflächen in den Randbereichen der Modulkomponente zu Randbereichen eines übergeordneten Schaltungsträgers nach dem jeweiligen Fixieren einer der Modulkomponenten aufgebracht. Weisen in einer bevorzugten Ausführungsform der Erfindung die Modulkomponenten als Verbindungselemente Flipchip-Kontakte auf, so können diese ebenfalls mit der Oberflächenmontage der Modulkomponenten mit entsprechenden Verbindungsstrukturen von darunter angeordneten Modulkomponenten verbunden werden.

Zum Aufeinanderstapeln der Modulkomponenten untereinander können doppelseitig klebende Folien eingesetzt werden. Derartige doppelseitig klebende Folien haben den Vorteil, dass sie für die Klebefunktion nicht speziell wie herkömmliche Klebstoffe strukturiert werden müssen. Ferner haben sie den Vorteil, dass ein Dosieren eines Klebstoffs auf entsprechenden zu verbindenden Flächen entfallen kann. Mit einer derartigen doppelseitig klebenden Klebstofffolie können die Zusammenbaukosten eines derartigen Halbleiterbauteils erheblich vermindert werden.

Ein Verfahren zur Herstellung eines Halbleiterbauteils aus Modulkomponenten weist die nachfolgenden Verfahrensschritte auf. Zunächst wird ein übergeordneter Schaltungsträger für das Halbleiterbauteil mit elektrischen Anschlussflächen für gestapelte Modulkomponenten hergestellt. Dieser Schaltungsträger kann mehrlagig ausgeführt sein und auf seiner Oberseite die Anschlussflächen für die gestapelten Modulkomponenten aufweisen, während auf seiner Unterseite oder Rückseite entsprechende Außenkontaktflächen vorhanden sind, an die weitere elektrische Leitungen anschließbar sind. Von den Anschlussflächen auf der Oberseite des übergeordneten Schaltungsträgers können Durchkontakte zu den Außenkontaktflächen auf der Unterseite des Schaltungsträgers führen.

Zeitlich und räumlich unabhängig von dem Herstellen des übergeordneten Schaltungsträgers werden die Modulkomponenten hergestellt, wobei eine Basismodulkomponente vorgesehen ist. Anschließend werden die Modulkomponenten auf dem Schaltungsträger gestapelt.

Je nach flächiger Erstreckung der Modulkomponenten erfolgt ein Zusammenschalten der Modulkomponenten untereinander und mit dem Schaltungsträger durch Herstellen von elektrischen Verbindungen über Verbindungselemente unmittelbar nach Anbringen einzelner Modulkomponenten oder nach Fertigstellung des gesamten Stapels. Abschließend kann der Schaltungsträger mit den gestapelten Modulkomponenten in ein Gehäuse eingebracht werden. Dieses Gehäuse kann das Gehäuse eines Mobilfunkgeräts darstellen.

In einer bevorzugten Durchführung des Verfahrens wird das Gehäuse aus einer Kunststoffmasse gebildet, in die das Halbleiterbauteil auf dem Schaltungsträger eingebettet wird.

Ein Vorteil dieses Verfahrens ist, dass dadurch ein Halbleiterbauteil mit räumlich geringeren Abmessungen als bisher übliche Halbleitermodule werden kann. Weiter hat das Verfahren den Vorteil, dass bisher übliche Komponenten wie Abstandshalter eingespart werden können. Dazu hat dieses Verfahren noch den Vorteil, dass auf engstem Raum bei verminderter Ausschussrate Halbleiterbauteile hergestellt werden können.

Zusammenfassend ist festzustellen, dass die erfindungsgemäße Lösung zur Realisierung von Abstandshaltern ein im sog. Frontendprozess aufgebrachtes Polymer nutzt, um preiswert einen Halbleitermodulstapel herzustellen. Dieses Polymer kann dasjenige sein, das als Wandstruktur insbesondere bei BAW-Filtern verwendet wird, um eine Hohlraumwand um die aktive Chipfläche in Form eines Piezoresonators zu erzeugen. So kann auf einfache Weise eine signifikante Verkleinerung der gesamten Bauteilgröße erreicht werden.

Die Stabilität von derartig zusammengesetzten Modulkomponenten ist gegenüber dem Stand der Technik beträchtlich erhöht. Ein solcher erfindungsgemäßer Spacer kann nämlich sogar um die Anschlußkontaktflächen eines Halbleiterchips herum ausgebildet werden, wobei nur ein kleiner, enger und nur seitlich weg führender Kanal für die Verbindungselemente offengelassen wird. Dabei können sehr geringe Abstände von wenigen Mikrometern (µm) von den Kontaktflächen erreicht werden. Dadurch ergibt sich eine große Auflagefläche auf dem Spacer. Dadurch wird auch eine nur geringe Kippneigung der beiden Modulkomponenten erreicht.

Darüber hinaus ist der zum Herstellen des besonders vorteilhaft verwendete Photolack wesentlich härter und unelastischer als die im Stand der Technik bekannten Klebetapes bzw. Klebebänder. Dies erhöht die Ausfallsicherheit der internen Kontaktierungen beträchtlich.

Zum Stapeln bzw. zum Herstellen von Verbindungen der Modulkomponenten untereinander und zu einem übergeordneten Schaltungsträger können neben einem Drahtbonden auch andere bekannte Arten der internen Verbindungsmöglichkeiten benutzt werden, beispielsweise durch Lotkugeln oder Flipchipverwandte Zwischenverbindungsmöglichkeiten. Selbst Durchkontaktierungen würden einen weiteren Fortschritt bedeuten. Au-βerdem können gemischte Technologien von Vorteil sein. Gemischte Technologien heißt in diesem Fall Flipchip-Technologie gemischt mit Lotkugel-Technik und/oder mit Drahtbond-Technik.

Die Erfindung wird nun anhand der beigefügten Figuren näher erläutert.
- Figur 1: zeigt einen schematischen Querschnitt durch ein Halbleiterbauteil gemäß einer ersten Ausführungsform der Erfindung,
- Figur 2: zeigt einen Teilbereich des Halbleiterbauteils aus Figur 1 in der Draufsicht und
- Figur 3: bis Figur 7 veranschaulichen Teilschritte bei der Herstellung des Halbleiterbauteils gemäß Figur 1 und Figur 2.

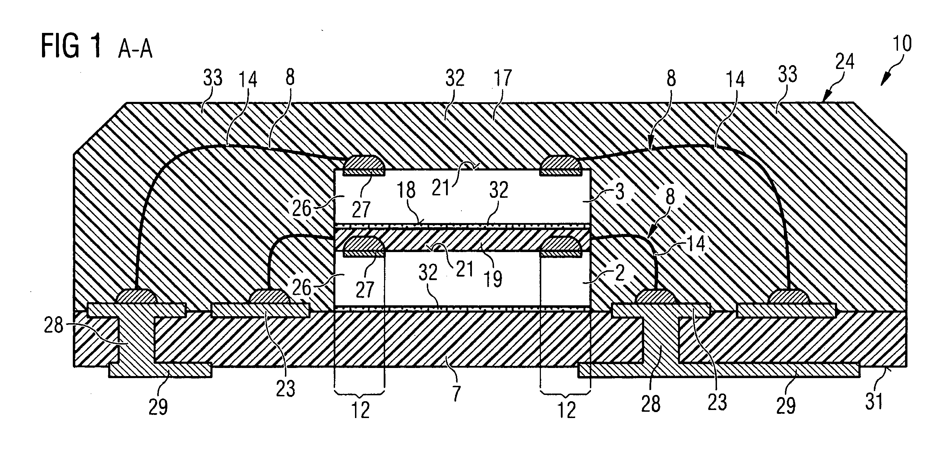

Figur 1 zeigt einen schematischen Querschnitt durch ein Halbleitermodul 10 gemäß einer ersten Ausführungsform der Erfindung. Das Halbleitermodul 10 ist auf einem übergeordneten Schaltungsträger 7 angeordnet. Das Halbleitermodul 10 stellt einen Stapel mit einer unteren Modulkomponente 2, die auch als Basismodulkomponente dient, und mit einer oberen Modulkomponente 3 dar, welche den gleichen Aufbau aufweist wie die Basismodulkomponente 2. Sowohl die Modulkomponente 2 als auch die Modulkomponente 3 sind Halbleiterchips mit hier nicht sichtbaren Schaltungsstrukturen.

Zwischen der Modulkomponente 2 und der Modulkomponente 3 ist ein Spacer 19 angeordnet, der als gehärtete Photolackstruktur ausgebildet ist. Der Spacer 19 ist in diesem Ausführungsbeispiel ca. 40 bis 50 µm hoch. In anderen, hier nicht gezeigten Ausführungsbeispielen werden vorteilhafterweise Höhen von 20 bis 40 µm oder 50µm bis 80 µm oder sogar 100µm verwendet, je nachdem, wie viel Platz für die Verbindungselemente 8 benötigt wird.

Diese Photolackstruktur auf der Basismodulkomponente 2 liegt an der Rückseite 18 der gestapelten Modulkomponente 3 an. Somit können im Randbereich 12 der Modulkomponenten 11, 12 Verbindungselemente 8 angeordnet werden, die hier als Bonddrähte ausgebildet sind.

An den Randbereichen 12 der Oberseite 21 der Basismodulkomponente 2 sind hierzu Kontaktflächen 27 angeordnet. Über Bonddrähte 14 sind diese Kontaktflächen 27 mit Anschlussflächen 23 des Schaltungsträgers 7 verbunden. Über Durchkontakte 28 durch den Schaltungsträger 7 hindurch stehen diese Anschlussflächen 23 mit Außenkontaktflächen 29 auf der Unterseite 31 des Schaltungsträgers 7 in Verbindung.

Wie man in Figur 1 besonders gut sieht, reicht der Spacer 19 sehr nahe an die Kontaktflächen 27 heran

Über den Schaltungsträger 7 werden die Modulkomponente 2 und die Modulkomponente 3 miteinander gekoppelt und ihre Signale werden zu den Außenkontaktflächen 29 des Schaltungsträgers 7 über die Durchkontakte 28 geliefert. Zum Schutz der Bonddrähte 14 ist das Halbleitermodul in eine Kunststoffgehäusemasse eingebettet.

Die Modulkomponenten 2 und 3 werden untereinander und mit dem Schaltungsträger 7 sowie mit der Abdeckplatte 12 durch entsprechend zugeschnittene doppelseitig klebende Folien 32 miteinander mechanisch verbunden. Je nach Anwendungsfall kann das Gehäuse 24 auch aus einer an den Schaltungsträger 7 anklinkbaren Gehäusekonstruktion bestehen oder aus einer Kunststoffgehäusemasse 33 aufgebaut sein.

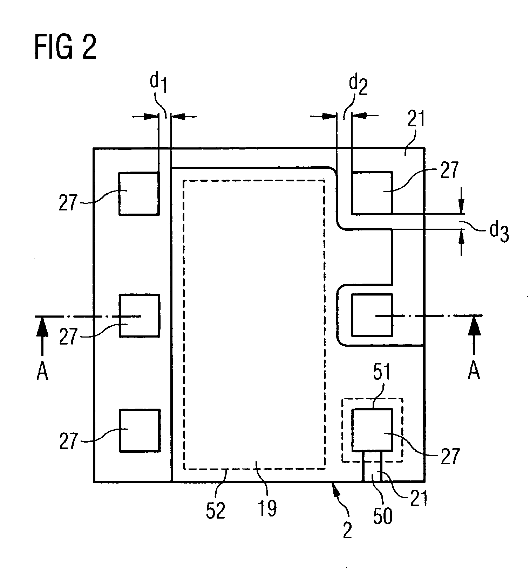

Figur 2 zeigt einen Teilbereich des Halbleitermoduls 10 aus Figur 1 in der Draufsicht, nämlich die Draufsicht auf die untere Modulkomponente 2 bei abgenommener Modulkomponente 3 und abgenommener Folie 32.

Wie man in dieser Ansicht besonders gut sieht, beträgt der Abstand d1 zwischen den linksseitigen Kontaktflächen 27 und dem Spacer 19 sehr gering, nämlich ca. 5µm. Dieser Abstand kann sehr gering gehalten werden, sogar bis ca. 1µm und darunter. Sogar Überdeckungen der Kontaktfläche 27 sind denkbar, so dass sich eine Abdichtung zwischen dem Randbereich der Kontaktflächen 27 und der Oberfläche 21 des Halbleiterchips 2 erreichen lässt. Beim Einsatz eines Isolators für den Spacer 19 kann sogar eine früher notwendige Passivierungsschicht entfallen, denn der Spacer 19 übernimmt dann deren Passivierungsfunktion. Dadurch wird eine Verunreinigung der Oberfläche 21 mit Radikalen in der Luft verhindert.

An der rechten Seite des Halbleiterchips 2 ist der Spacer mit weiteren Varianten der Gestaltung des Spacers 19 im Bereich um Kontaktflächen 27 herum gezeigt. In der rechten oberen Ecke und in der Mitte des Halbleiterchips 2 erstreckt sich der Spacer 19 fingerartig mit einem Abstand d2 und d3 jeweils um die Kontaktflächen 27 herum.

Die Abstände d1, d2 und d3 sind hier ca. 5µm groß. Sie können auch größer gewählt werden, beispielsweise 10µm oder 20µm aber auch bis zu 40µm oder 80 µm, wodurch auch ungenaues Arbeiten zum Erzeugen des Spacers möglich ist.

Noch vorteilhafter ist es, den Spacer 19 um die Kontaktfläche 27 herum zu führen, wie es in der rechten unteren Ecke des Halbleiterchips 2 gezeigt ist, wobei eine Abdichtung und Passivierung erfolgt. Es bleibt dann nur ein schmaler Kanal 50 mit einer Breite von ca. 20-30µm übrig, durch den ein Bonddraht gelegt werden kann. Das Bonden kann dann noch durch ein Fenster 51 im Spacer 19 erfolgen, dessen Breite gerade so groß gehalten wird, dass das Bondwerkzeug mit der Spitze seines Stichels die Bondverbindung erzeugen kann. Die geringe, nicht vom Spacer 19 bedeckte Oberfläche des Halbleiterchips 2 ist dann zwar nicht passiviert, was sich durch deren großen Abstand von den aktiven Bauelementen der integrierten Schaltung auf dem Halbleiterchip 2 nicht bemerkbar macht. Deren Ort ist in Figur 2 mit einer gestrichelten Linie 52 markiert.

Gerade wenn der Spacer 19 bis in den Randbereich des Halbleiterchips 2 ausgebildet wird, ergeben sich wesentliche Vorteile hinsichtlich der Stabilität der Anordnung, wenn danach der oben liegende Halbleiterchip 3 gebondet wird. Unmittelbar unterhalb dessen Kontaktflächen 27 liegt nämlich der Spacer 19 mit seinen entsprechenden Teilbereichen als Stütze an, durch welche der Kraftfluß beim Bonden der oberen Bonddrähte 14 verläuft. Dadurch wird die Mikrorissgefahr vermindert, die beim Bonden der in Figur 1 und Figur 2 links gelegenen Kontaktflächen besteht. Der über den Spacer 19 überstehende Bereich des oberen Halbleiterchips 3 wird nämlich beim Bonden auf Biegung belastet, wodurch in dessen Oberfläche 21 an der Stelle der größten Zugbelastung Mikrorisse provoziert werden.

Bei den in Figur 1 und Figur 2 rechts gelegenen Kontaktflächen des oberen Halbleiterchips 3 ist diese Gefahr durch die Stützfunktion des Spacers 19 vermindert.

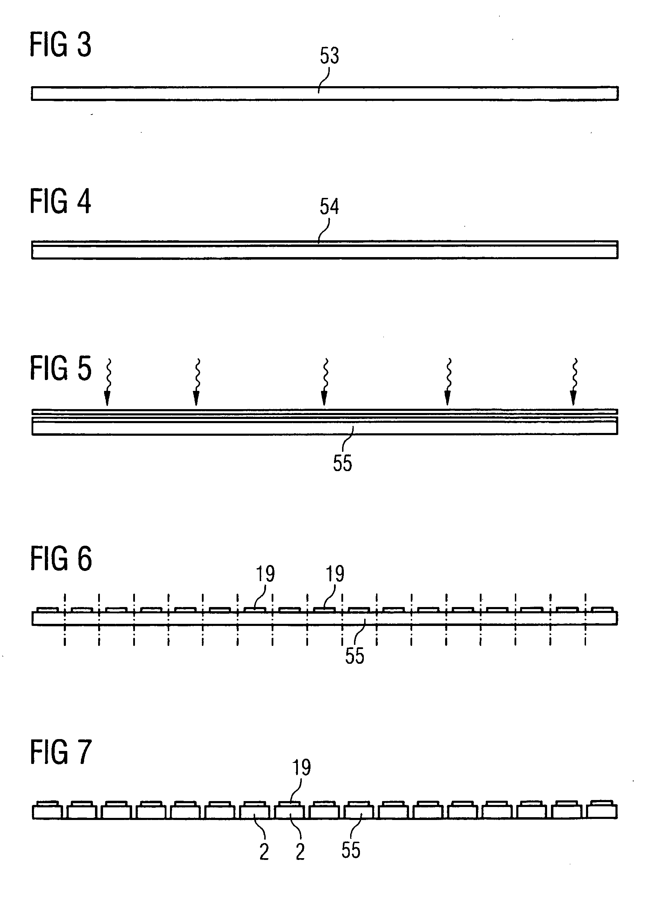

Figur 3, Figur 4, Figur 5, Figur 6 und Figur 7 veranschaulichen ein Verfahren zur Herstellung der erfindungsgemäßen elektronischen Bauteile.

Zunächst wird gemäß Figur 3 ein Halbleiterwafer 53 mit Halbleiterchippositionen bereitgestellt, die Schaltungsstrukturen in vorbestimmten Oberflächenbereichen aufweisen. Auf diesen Halbleiterwafer wird gemäß Figur 4 eine Kunststoffschicht 54 aufgebracht, aus der gemäß Figur 5 und Figur 6 mit Hilfe eines Photolithographieverfahrens die Spacer 19 strukturiert werden. Diese Kunststoffschicht 54 ist nur wenige Mikrometer dick und kann bis zu 200 µm Dicke aufweisen.

Vor einem Trennen durch Zersägen des Halbleiterwafers in erste Halbleiterchips wird auf die Rückseite des Halbleiterchips eine Klebefolie 55 aufgebracht. Diese Klebefolie 55 sorgt dafür, dass der Halbleiterwafer 53 sich beim späteren Trennen in erste Halbleiterchips 2 mit anhaftender Klebefolie nicht verschiebt. Nach dem Trennen des Halbleiterwafers 53 in erste Halbleiterchips 2 mit anhaftender Klebefolie 55 gemäß Figur 2 werden die Halbleiterchips 2 auf einen hier nicht gezeigten Metallrahmen für flachleiterfreie Gehäuse unter Aufkleben des Halbleiterchips 2 und Aushärten der Klebefolie 55 auf der Rückseite des Halbleiterchips 2 aufgebracht.

Auch hier dient die Klebefolie 55 dazu, den Halbleiterchip 2 zu fixieren, und zwar auf Innenflächen von Außenkontakten. Dieses Fixieren unterstützt ein sicheres Bonden der Kontaktflächen auf der Oberseite des Halbleiterchips mit Kontaktanschlußflächen auf den Innenflächen der Außenkontakte.

Die weiteren Prozessschritte zur Herstellung des Halbleitermoduls 10 werden nicht in eigenen Figuren gezeigt.

Die Kontaktanschlußflächen können gegenüber den Metallen der Außenkontakte eine bondbare Veredelungsschicht aufweisen. Derartige Veredelungsschichten weisen Gold oder Legierungen von Gold auf. Sie unterstützen das Herstellen von Bondverbindungen zwischen Kontaktflächen auf der Oberseite des Halbleiterchips und Innenflächen von Außenkontakten des Metallrahmens.

Danach wird der Hohlraumrahmen mit dem zweiten Halbleiterchip abgedeckt. Dazu weist das zweite Halbleiterchip auf seiner Rückseite ebenfalls eine Klebefolie auf, die der Klebefolie des ersten Halbleiterchips entspricht. Diese Klebefolie auf der Rückseite des zweiten Halbleiterchips sorgt dafür, dass Unebenheiten des Spacers ausgeglichen werden. Nach dem Anbringen des zweiten Halbleiterchips kann ein Verpacken der Halbleiterchips mit den Bonddrähten in einer Kunststoffgehäusemasse erfolgen. Dabei werden die Bonddrähte, die Halbleiterchips und auch der Spacer 19 in die Kunststoffmasse eingebettet. Lediglich die Außenkontakte an der Unterseite des elektronischen Bauteils bleiben frei zugänglich.

Nach erfolgtem Verpacken der Halbleiterchips in der Gehäusekunststoffmasse kann der Metallrahmen, der eine Vielzahl von elektronischen Bauteilen aufgenommen hat, in einzelne elektronische Bauteile getrennt werden. Dieses Verfahren hat den Vorteil, dass auf Waferebene relativ preiswert sowohl der Hohlraumrahmen, als auch die erste und zweite Klebefolie für mehrere elektronische Bauteile gleichzeitig vorbereitet werden kann. Es können folglich mehrere bewährte Schritte, die aus der Halbleitertechnologie bekannt sind, eingesetzt werden.

Insbesondere ist das der Fall, wenn auf die Oberseite des Halbleiterwafers eine Photolackschicht aufgebracht wird, die anschließend photolithographisch zu Spacern 19 strukturiert wird. Bei diesem Photostrukturieren können die Schaltungsstrukturen auf dem Halbleiterchip vollständig und die Kontaktflächen soweit notwendig teilweise frei von Photolack gehalten werden. Dazu kann ein Photolack mit der handelsüblichen Abkürzung SU8 eingesetzt werden. Dieser läst sich feinst strukturieren, um nur an vorgegebenen Stellen des Halbleiterchips mehrere Hohlräume, die durch kleine Stege unterteilt sind, zu schaffen. Somit lässt sich ein äußerst kleiner, miniaturisierter Footprint herstellen. Bei größeren Strukturen können auch Drucktechniken angewandt werden, um die Spacer zu realisieren. In diesem Zusammenhang sind von besonderem Vorteil Siebdrucktechniken oder Maskendrucktechniken, bei denen lediglich die Spacer an sich in Form von Blöcken hergestellt werden, während die zum nachfolgenden Verbinden notwendigen bereiche frei von Kunststoff bleiben. Sowohl die erste, als auch die zweite Klebefolie auf den Rückseiten der Halbleiterchips können aus UV-vorhärtbarem Material bestehen und werden vor dem Trennen durch eine Diamantsäge UV-bestrahlt, um eine Fixierung in der Trennanlage aufgrund der Vorhärtung durch ultraviolettes Licht zu erreichen. Über eine reine Vorhärtung mit UV-Licht hinaus können die erste und die zweite Klebefolie thermisch aushärtbar sein. Ein entsprechender thermischer Aushärteschritt kann nach dem Aufbringen des Halbleiterchips mit erster Klebefolie auf Innenflächen von Außenkontakten eines Metallrahmens erfolgen und vor dem Bonden der Bondverbindungen. Damit wird gewährleistet, dass während des Bondens ein Verschieben des Halbleiterchips nicht möglich ist.

### Bezugszeichenliste

- 2: Basismodulkomponente
- 3: Modulkomponente
- 7: Schaltungsträger
- 8: Verbindungselement
- 10: Halbleitermodul
- 11: Modulkomponente
- 12: Randbereich
- 14: Bonddrähte
- 18: Rückseite
- 19: Spacer
- 21: Oberfläche
- 23: Anschlussfläche
- 24: Gehäuse
- 27: Kontaktfläche
- 28: Durchkontakt
- 29: Außenkontaktfläche
- 31: Unterseite
- 32: Folie
- 50: Kanal
- 51: Fenster
- 52: gestrichelte Linie
- 53: Halbleiterwafer
- 54: Kunststoffschicht
- 55: Klebefolie

## Patentansprüche

1. Halbleiterbauteil mit einer ersten Modulkomponente (2) und mit einer zweiten Modulkomponente (3), wobei ein Abstandshalter (19) zwischen den beiden aufeinander gestapelten Modulkomponenten (2, 3) angeordnet ist und wobei die Modulkomponenten (2, 3) elektrisch untereinander und/oder mit einem übergeordneten Schaltungsträger (7) über Verbindungselemente (8) elektrisch in Verbindung stehen, wobei an wenigstens einer Stelle die lichte Weite zwischen dem Abstandshalter (19) und einer Kontaktfläche (27) der unteren Modulkomponente (2) kleiner als 80µm und insbesondere kleiner als 40µm ist,
**dadurch gekennzeichnet, dass**
eine Kontaktfläche (27) der unteren Modulkomponente (2) wenigstens an einer Seite fingerartig von einem Teilbereich des Abstandshalters (19) umgeben ist.

2. Halbleiterbauteil nach Anspruch 1,
**dadurch gekennzeichnet, dass**
an wenigstens einer Stelle der Abstand zwischen dem Abstandshalter (19) und einer Kontaktfläche (21) der unteren Modulkomponente (2) kleiner als 20µm und insbesondere kleiner als 10µm ist.

3. Halbleiterbauteil nach Anspruch 2,
**dadurch gekennzeichnet, dass**
an wenigstens einer Stelle der Abstand zwischen dem Abstandshalter (19) und einer Kontaktfläche (27) der unteren Modulkomponente (2) kleiner als 5µm und insbesondere kleiner als 1µm ist.

4. Halbleiterbauteil nach Anspruch 1
**dadurch gekennzeichnet, dass**
der Abstandshalter (19) an wenigstens einer Stelle eine Kontaktfläche (27) der unteren Modulkomponente (2) unter Freilassung eines Teilbereichs (51) der Kontaktfläche (27) überdeckt.

5. Halbleiterbauteil nach Anspruch 4,
**dadurch gekennzeichnet, dass**
im Abstandshalter (19) an wenigstens einer Stelle ein Kanal (50) von der Kontaktfläche (27) zu einem Randbereich der unteren Modulkomponente (2) führt, wobei am Boden des Kanals (50) ein Teilbereich einer Oberfläche (21) der unteren Modulkomponente (2) freigelassen ist.

## Claims

1. Semiconductor component comprising a first module component (2) and a second module component (3), wherein a spacer (19) is arranged between the two module components (2, 3) which are stacked one on top of the other, and wherein the module components (2, 3) are electrically connected to one another and/or to a superordinate circuit carrier (7) via connecting elements (8), wherein the clear width between the spacer (19) and a contact area (27) of the lower module component (2) is less than 80 µm and in particular less than 40 µm at at least one point, **characterized in that** a contact area (27) of the lower module component (2) is surrounded on at least one side in the manner of a finger by a subregion of the spacer (19).

2. Semiconductor component according to Claim 1, **characterized in that** the distance between the spacer (19) and a contact area (21) of the lower module component (2) is less than 20 µm and in particular less than 10 µm at at least one point.

3. Semiconductor component according to Claim 2, **characterized in that** the distance between the spacer (19) and a contact area (27) of the lower module component (2) is less than 5 µm and in particular less than 1 µm at at least one point.

4. Semiconductor component according to Claim 1, **characterized in that** the spacer (19) covers a contact area (27) of the lower module component (2) at at least one point, whilst leaving free a subregion (51) of the contact area (27).

5. Semiconductor component according to Claim 4, **characterized in that** a channel (50) leads from the contact area (27) to a peripheral region of the lower module component (2) at at least one point in the spacer (19), wherein a subregion of a surface (21) of the lower module component (2) is left free at the bottom of the channel (50).

## Revendications

1. Composant à semi-conducteur ayant un premier élément (2) de module et un deuxième élément (3) de module, un intercalaire (19) étant disposé entre les deux éléments (2, 3) de module empilés l'un sur l'autre et les éléments (2, 3) de module étant en relation électriquement entre eux et/ou électriquement par des éléments (8) de liaison avec un support (7) de circuit supérieur, dans lequel, en au moins un point, l'espace ouvert entre l'intercalaire (19) et une surface (27) de contact de l'élément (2) inférieur de module est plus petit que 80µm et notamment plus petit que 40µm,
**caractérisé en ce que**
une surface (27) de contact de l'élément (2) inférieur du module est entourée, au moins d'un côté, à la manière d'un doigt, par une zone partielle de l'intercalaire (19).

2. Composant à semi-conducteur suivant la revendication 1,
**caractérisé**
**en ce qu'**en au moins un point, la distance entre l'intercalaire (19) et une surface (21) de contact de l'élément (2) inférieur du module est plus petite que 20µm et notamment plus petite que 10µm.

3. Composant à semi-conducteur suivant la revendication 2,
**caractérisé**
**en ce qu'**en au moins un point, la distance entre l'intercalaire (19) et une surface (27) de contact de l'élément (2) inférieur du module est plus petite que 5µm et notamment plus petite que 1µm.

4. Composant à semi-conducteur suivant la revendication 1,
**caractérisé en ce que**
l'intercalaire (19) recouvre, en au moins un point, une surface (27) de contact de l'élément (2) inférieur du module, en laissant libre une zone (51) partielle de la surface (27) de contact.

5. Composant à semi-conducteur suivant la revendication 4,
**caractérisé en ce que**
dans l'intercalaire (19), en au moins un point, un canal (50) va de la surface (27) de contact à une zone de bord de l'élément (2) inférieur du module, une zone partielle d'une surface (21) de l'élément (2) inférieur du module étant laissée libre au fond du canal (50).
